(19) Europäisches Patentamt
European Patent Office
Office européen des brevets

(11) **EP 4 756 441 A1**

(12) **EUROPÄISCHE PATENTANMELDUNG**

(43) Veröffentlichungstag:
**10.06.2026 Patentblatt 2026/24**

(51) Internationale Patentklassifikation (IPC):
*G01R 31/00* *(2006.01)*

(21) Anmeldenummer: **25219849.4**

(52) Gemeinsame Patentklassifikation (CPC):
**G01R 31/001; G01R 31/002**

(22) Anmeldetag: **01.12.2025**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: **04.12.2024 DE 102024136054**

(71) Anmelder: **Volkswagen Aktiengesellschaft 38440 Wolfsburg (DE)**

(72) Erfinder: **Rabe, Hanno 38440 Wolfsburg (DE)**

(54) **VERFAHREN UND MESSANORDNUNG ZUM BESTIMMEN VON ELEKTRISCHEN GRÖSSEN FÜR EIN VERHALTENSMODELL EINER ELEKTRISCHEN ODER ELEKTRONISCHEN STÖRQUELLE**

(57) Die Erfindung betrifft ein Verfahren und eine Messanordnung (10) zum Bestimmen von elektrischen Größen für ein Verhaltensmodell einer elektrischen oder elektronischen Störquelle (12).

Es ist vorgesehen, dass eine elektrische oder elektronische Störquelle (12), insbesondere eine EMV-Stör- quelle, mittels einer aktiven Lastmodulation, die zeitlich und spektral optimale Modulationen ermöglicht, durch eine In-Situ-kalibrierbaren Messanordnung (10) charak- terisiert wird. Eine derartige messtechnische Charakte- risierung einer EMV-Störquelle kann für die Einbindung in die virtuelle Absicherung verwendet werden.

Fig. 2

**Beschreibung**

Die Erfindung betrifft ein Verfahren und eine Messanordnung zum Bestimmen von elektrischen Größen für ein Verhaltensmodell einer elektrischen oder elektronischen Störquelle, insbesondere ein EMV-Verhaltensmodell (EMV: elektromagnetische Verträglichkeit) für die Simulation von elektromagnetischen Störemissionen von Komponenten, beispielsweise eines Elektromotors, einer Zündkerze, einer Radioempfangseinheit und dergleichen, um ein Verhalten der Komponente in einem realen System vorherzusagen.

In der Praxis wird das EMV-Verhalten von elektrischen oder elektronischen Komponenten in einem System simuliert, um festzustellen, ob ein störungsfreier Betrieb des Systems möglich ist, und ob die Belastung der Umgebung durch elektromagnetische Strahlung des Systems die vorgegebenen Grenzwerte nicht überschreitet.

In der Druckschrift DE 10 2021 214 761 B3 wird ein Verfahren und eine Messanordnung zum Bestimmen von elektrischen Größen für ein Verhaltensmodell einer elektrischen oder elektronischen Störquelle offenbart. Hierbei werden verschiedene Lastzustände mittels einer Schaltung von passiven Impedanzen erzielt und eine Kalibrierung der Messanordnung erfolgt mittels eines vektoriellen Netzwerkanalysators.

Eine Bestimmung von Störquellen basierend auf arbiträren Testsignalen wird in der Druckschrift WO 2021 / 136 792 A1 beschrieben.

Ein Verfahren und eine Vorrichtung zum Bereitstellen eines Verhaltensmodells für die Simulation von elektromagnetischen Störemissionen einer elektrischen bzw. elektronischen Komponente offenbart die Druckschrift DE 10 2019 212 808 A1.

Die Druckschrift US 2013 / 0 238 264 A1 betrifft eine Messvorrichtung zur Identifizierung einer elektromagnetischen Störungsquelle und ein Verfahren zu ihrer Schätzung.

Zur Bestimmung der elektrischen Größen einer Störquelle wird demnach eine aktive Lastmodulation oder eine Schaltung von passiven Impedanzen zur Lastmodulation vorgeschlagen. Bei der Schaltung der passiven Impedanzen wird ferner eine mittels eines Netzwerkanalysators durchgeführte Kalibrierung angewendet. Im ersten Fall, also bei Messungen ohne vorherige Kalibrierung, entstehen systematische Fehler der Messwerte, die insbesondere bei höheren Messfrequenzen deutlich in Erscheinung treten. Insofern ist eine derartige Lösung, trotz der in Kauf genommenen systematischen Fehler, nur für Messungen von Störquellen mit niedrigen Frequenzen geeignet. Aber auch bei der Fehlerkorrektur mittels einer vorhergehenden Messsystemcharakterisierung unter Verwendung eines Netzwerkanalysators werden ebenfalls unerwünschte Fehler beobachtet.

Der Erfindung liegt daher nun die Aufgabe zugrunde, ein Verfahren und eine Messanordnung bereitzustellen, die die Bestimmung der elektrischen Größen für ein Verhaltensmodell einer elektrischen oder elektronischen Störquelle verbessern.

Die erfindungsgemäße Aufgabe wird gelöst durch ein Verfahren und eine Messanordnung zum Bestimmen von elektrischen Größen für ein Verhaltensmodell einer elektrischen oder elektronischen Störquelle gemäß den unabhängigen Patentansprüchen. Bevorzugte Weiterbildungen sind Gegenstand der jeweils rückbezogenen Unteransprüche.

Ein erster Aspekt betrifft ein Verfahren zum Bestimmen von elektrischen Größen für ein Verhaltensmodell einer elektrischen oder elektronischen Störquelle, vorzugsweise ein EMV-Verhaltensmodell für die Simulation von elektromagnetischen Störemissionen von Komponenten, beispielsweise eine Komponente eines Kraftfahrzeugs, wie beispielsweise ein Elektromotor, eine Zündkerze, eine Radioempfangseinheit und dergleichen, um ein Verhalten der Komponente in einem realen System vorherzusagen. Mithilfe von EMV-Verhaltensmodellen wird der Entwicklungsprozess und der Prozess der Evaluierung des Einsatzes der Komponente innerhalb eines Systems erheblich vereinfacht, insbesondere wenn die Komponente ein lineares und zeitinvariantes Verhalten aufweist. Derartige Verhaltensmodelle verwenden einen Anschluss-Äquivalenzschaltkreis, der das Verhalten der Komponente an den Anschlüssen wiedergibt, anstatt alle Interferenzquellen und Kopplungseffekte innerhalb der Komponente zu modellieren. Konventionelle Ansätze verwenden beispielsweise einen Äquivalenzschaltkreis basierend auf Norton oder Thevenin. Beispielsweise verwendet die Thevenin-Theorie Impedanzelemente in Kombination mit Spannungsquellen, um das Verhalten eines Anschlusses der Komponente zu modellieren.

Gemäß einem Verfahrensschritt wird ein erster Port einer Kopplungseinheit mit der Störquelle verbunden. Mit anderen Worten wird ein auf seine Störemission zu überprüfender Prüfling, also eine elektrische oder elektronische Komponente, bevorzugt eine Komponente eines Fahrzeugs, insbesondere eines Kraftfahrzeugs, an die Kopplungseinheit angeschlossen.

In einem weiteren Schritt des Verfahrens wird ein erster Lastzustand hergestellt. Dies erfolgt durch Einspeisen eines ersten Modulationssignals in die Kopplungseinheit durch ein mit einem zweiten Port der Kopplungseinheit verbundenes Messsystem. Mit anderen Worten weist die Kopplungseinheit mindestens zwei Ports, auch (elektrische) Messtore genannt, auf, über welche die Kopplungseinheit mit dem Messsystem und mit der Störquelle verbunden beziehungsweise verbindbar ist. Ein Messtor umfasst zwei Pole, vorzugsweise einen unabhängigen Pol und einen Bezugspol. Der erste Port und der zweite Port, und vorzugsweise noch weitere Ports, teilen sich bevorzugt einen Bezugspol. Der Bezugspol ist beispielsweise ein (gemeinsamer) Massepol. Von dem Messsystem wird das (erste) Modulationssignal über den zweiten Port in die Kopplungseinheit eingespeist und gelangt von dort über den ersten Port der Kopplungseinheit zu der Störquelle. Durch das Modulationssignal hervorgerufene Dynamiken in der Störquelle gelangen Störemissionen der Störquelle und/oder Streuerscheinungen an dem ersten Port in Gestalt eines oder mehrerer hochfrequenter (HF) Signale über den ersten Port zurück in die Kopplungseinheit. HF-Signale (englisch RF - radio frequency) liegen in einem Frequenzbereich, der oberhalb der Frequenzen von (für den Menschen) hörbaren Schallwellen liegt. Bevorzugt umfassen die hierin genannten HF-Signale Frequenzen zwischen 20 kHz bis 300 GHz.

In einem weiteren Verfahrensschritt werden in dem ersten Lastzustand an dem ersten Port anliegende hochfrequente Signale (durch die Kopplungseinheit) ausgekoppelt und an das Messsystem weitergeleitet. Die an dem ersten Port anliegenden hochfrequenten Signale umfassen beispielsweise die Störemissionen der Störquelle, die basierend auf den durch das Modulationssignal hervorgerufenen Dynamiken in der Störquelle entstehen, und/oder den Streuerscheinungen an dem ersten Port. Bevorzugt werden ein erster Anteil eines ersten HF-Signals, welches ausgehend von der Last in Richtung der Störquelle durch die Kopplungseinheit läuft, und/oder ein zweiter Anteil eines zweiten HF-Signals, welches ausgehend von der Störquelle in Richtung der Last durch die Kopplungseinheit läuft, ausgekoppelt. Bevorzugt erfolgt das Auskoppeln der hochfrequenten Signale unter Verwendung von zwei Messstellen. Bevorzugte Beispiele für derartige Systeme sind ein Richtkoppler, der dazu eingerichtet ist, die an dem ersten Port anliegenden hochfrequente Signale, vorzugsweise den ersten Anteil des ersten HF-Signals und/oder den zweiten Anteil des zweiten HF-Signals, auszukoppeln, oder eine Messzange und ein Oszillatortastkopf. Durch das Auskoppeln und Weiterleiten der beiden Anteile der HF-Signale (in dem ersten Lastzustand) wird eine Messung der Wellengrößen der HF Signale an dem ersten Port durch das Messsystem ermöglicht. Bevorzugt umfasst die Kopplungseinheit einen dritten Port zum Auskoppeln und Weiterleiten des ersten HF-Signals und einen vierten Port zum Auskoppeln und Weiterleiten des zweiten HF-Signals an das Messsystem. Mit anderen Worten ist das Messsystem in diesem Fall über drei Ports mit der Kopplungseinheit verbunden. Dadurch, dass jedes der beiden HF-Signale durch einen eigenen Port ausgekoppelt wird, wird eine voneinander entkoppelte Übertragung der HF-Signale ermöglicht, was die Messung der jeweiligen Wellengrößen durch das Messsystem vereinfacht.

Gemäß einem weiteren Schritt des Verfahrens wird ein zweiter Lastzustand hergestellt. Dies erfolgt durch Einspeisen eines von dem ersten Modulationssignal unterschiedlichen zweiten Modulationssignals in die Kopplungseinheit durch das Messsystem. Analog zu dem ersten Modulationssignal wird das zweite Modulationssignal von dem Messsystem über den zweiten Port in die Kopplungseinheit eingespeist und gelangt von dort über den ersten Port der Kopplungseinheit zu der Störquelle. Erneut gelangen durch die durch das (zweite) Modulationssignal verursachte Dynamiken in der Störquelle verursachte Störemissionen der Störquelle und/oder Streuerscheinungen an dem ersten Port in Gestalt eines oder mehrerer HF-Signale über den ersten Port zurück in die Kopplungseinheit.

In einem weiteren Verfahrensschritt werden in dem zweiten Lastzustand an dem ersten Port anliegende hochfrequente Signale (durch die Kopplungseinheit) ausgekoppelt und an das Messsystem weitergeleitet. Bevorzugt werden ein dritter Anteil eines dritten HF-Signals, welches ausgehend von der Last in Richtung der Störquelle durch die Kopplungseinheit läuft, und/oder ein vierter Anteil eines vierten HF-Signals, welches ausgehend von der Störquelle in Richtung der Last durch die Kopplungseinheit läuft, ausgekoppelt. Durch das Auskoppeln und Weiterleiten der beiden Anteile der HF-Signale (in dem zweiten Lastzustand) wird analog eine Messung der Wellengrößen der HF-Signale an dem ersten Port durch das Messsystem ermöglicht, dieses Mal jedoch in dem unterschiedlichen zweiten Lastzustand. Mit anderen Worten liegen dem Messsystem entsprechende HF-Signale der Störquelle bei zwei unterschiedlichen Lastzuständen vor. Bevorzugt werden das dritte HF-Signal und das vierte HF-Signal analog zum ersten HF-Signal und zweiten HF-Signal über den dritten beziehungsweise vierten Port ausgekoppelt und an das Messsystem weitergeleitet. Die jeweilige Einspeisung des Modulationssignals und die jeweilige Messung der Lastzustände werden bevorzugt jeweils nacheinander durchgeführt.

Ferner werden absolute Wellengrößen aus den jeweils in den beiden Lastzuständen ausgekoppelten hochfrequenten Signalen ermittelt. Die erfassten Anteile der hochfrequenten Signale werden bevorzugt mittels einer mathematischen Operation in den Frequenzbereich überführt, beispielsweise mittels einer Fouriertransformation. Das Ermitteln der Wellengrößen erfolgt basierend auf in einer Speichereinheit des Messsystems hinterlegten Ergebnissen einer relativen und einer absoluten Kalibrierung der mit dem Messsystem verbundenen Kopplungseinheit. Mit anderen Worten sind in der Speichereinheit Kalibrierparameter hinterlegt, mit denen eine Übertragungsfunktion der Kopplungseinheit in einem mit dem Messsystem verbundenen Zustand abgebildet wird. Anders gesagt, werden bei der Berechnung der absoluten Wellengrößen systematische Fehler vermieden, die dadurch bedingt sind, dass die Kalibrierung mit einem anderen Messsystem erfolgt, als das Messsystem zur (späteren) Messung der Störquelle, wie es beispielsweise bei der Verwendung eines Netzwerkanalysators der Fall ist. Die Wellengrößen der jeweils ausgekoppelten hochfrequenten Signale der beiden Lastzustände werden bevorzugt über eine vorgegebene Bandbreite durch das Messsystem phasenkohärent erfasst.

In einem weiteren Verfahrensschritt werden Ströme und Spannungen in den beiden Lastzuständen basierend auf den absoluten Wellengrößen bestimmt.

Mit anderen Worten wird im Frequenzbereich mittels einer mathematischen Operation eine elektrische Spannung und ein elektrischer Strom an dem ersten Port der Kopplungseinheit in jedem der beiden Lastzuständen ermittelt.

In einem weiteren Schritt des Verfahrens wird eine Impedanz ausgehend von einem Verhältnis einer durch die zwei Lastzustände hervorgerufenen Spannungsdifferenz zu einer hervorgerufenen Stromdifferenz bestimmt.

Ferner wird eine Störquellenspannung, ein Störquellenstrom und/oder eine Störleistungswelle (der Störquelle) basierend auf der Impedanz bestimmt. Beispielsweise wird die Störquellenspannung, der Störquellenstrom und/oder die Störleistungswelle basierend auf der Impedanz und dem bestimmten Strom und/oder der bestimmten Spannung an der Störquelle in einem der oder in beiden Lastzuständen bestimmt. Die Störquellenspannung, der Störquellenstrom und die Störleistungswelle stellen die wesentlichen elektrischen Größen für das Verhaltensmodell der elektrischen oder elektronischen Störquelle dar.

Erfindungsgemäß erfolgt demnach eine Bestimmung der elektrischen Größen einer Störquelle mittels einer aktiven Lastmodulation, welche durch die beiden Modulationssignale zum Herstellen der unterschiedlichen Lastzustände erfolgt. Die aktive Lastmodulation bietet eine hohe Flexibilität hinsichtlich der (gewünschten) Lastzustände. Bevorzugt werden mehr als zwei, bevorzugt vier, fünf, sechs oder mehr unterschiedliche Lastzustände angelegt und die Ströme und Spannungen in den jeweiligen Lastzuständen bestimmt. Dies hat den Vorteil, dass für Bestimmung der Impedanz die für die Messdynamik vorteilhaftesten Zustände ausgewählt werden können und somit die Genauigkeit der Impedanzbestimmung (und der nachfolgend bestimmten Parameter) verbessert wird. Die Modulationssignale können zeitlich und spektral im Wesentlichen beliebig gestaltet werden, wodurch zeitlich und spektral optimierte Modulationen der Lasten möglich sind, um die Störquelle optimaler zu charakterisieren. Eine manuelle Veränderung der Lasten mittels Schalten von passiven Impedanzen erlaubt keine derartige Flexibilität. Aber auch bei der Fehlerkorrektur mit einem Netzwerkanalysator treten zusätzliche systematische Fehler auf, die dadurch bedingt sind, dass die Kalibrierung mit einem anderen Messsystem erfolgt, als das Messsystem zur (späteren) Messung der Störquelle. Da die Kalibrierung und zugleich die Messung mit dem Messsystem erfolgen, werden derartige systematische Fehler ebenfalls vermieden. Mit anderen Worten werden erfindungsgemäß die Vorteile einer kalibrierten Messung mit denen einer aktiven Modulation der Störquelle kombiniert, sodass ein Auftreten der Messfehler verringert wird. Dadurch, dass das mit der Kopplungseinheit verbundene Messsystem ein für die Kalibrierung erforderliches Signal bereitstellen kann, ist erfindungsgemäß eine In-Situ-Kalibrierung über die gesamte Messanordnung aus Kopplungseinheit und Messsystem möglich.

In bevorzugter Ausgestaltung ist vorgesehen, dass vor dem Verbinden des ersten Ports der Kopplungseinheit mit der Störquelle der erste Port der Kopplungseinheit mit einer ersten Kalibriereinheit verbunden und eine relative Kalibrierung der mit dem Messsystem verbundenen Kopplungseinheit unter Verwendung der ersten Kalibriereinheit und des Messsystems durchgeführt werden. Die relative Kalibrierung dient bevorzugt dem Zweck, einen Quotienten aus dem ersten Anteil des ersten HF-Signals und dem zweiten Anteil des zweiten HF-Signals zu bestimmen, beispielsweise der Ermittlung eines Reflektionsfaktors), am ersten Port. Bei der relativen Kalibrierung ist die Messung von absoluten Größen der Anteile der ersten und zweiten HF-Signal nicht erforderlich. Ferner werden (vor dem Verbinden des ersten Ports der Kopplungseinheit) das Ergebnis der relativen Kalibrierung in der Speichereinheit des Messsystems hinterlegt und der erste Port der Kopplungseinheit von der ersten Kalibriereinheit getrennt. Da die Signalwege und die Kopplungseinheit die tatsächlichen Wellengrößen an der Störquelle bis zu den Ports, also den eigentlichen Messtoren, verfälschen, wird vor der Messung der hochfrequenten Signalen in den beiden Lastzuständen mit der gleichen Messanordnung eine relative Kalibrierung durchgeführt und die Ergebnisse der relativen Kalibrierung in der Speichereinheit des Messsystems hinterlegt. Insofern stehen aktualisierte relative Kalibrierungsparameter zur Verfügung, um die absoluten Wellengrößen der ausgekoppelten hochfrequenten Signale mit einem möglichst geringen systematischen Messfehler bestimmen zu können. Die erste Kalibriereinheit ist beispielsweise ein ohmscher Widerstand, vorzugsweise mit 50 Ohm. Die relative Kalibrierung wird bevorzugt durchgeführt, indem das Messsystem ein Signal in die Kopplungseinheit einspeist und zugleich die dabei auftretenden Signaländerungen durch einen Messempfänger, beispielsweise ein Oszilloskop oder ein Digitizer, im Messsystem erfasst werden. Damit lässt sich die Messung von Sende- und Empfangssignal als relative Messung gestalten und die Messwerte zueinander in Relation setzen (daher relative Kalibrierung).

Als relatives Kalibrierungsverfahren wird bevorzugt ein 3-Term-Kalibrierungsverfahren durchgeführt. 3-Term-Kalibrierungsverfahren beziehen sich auf die Verwendung von drei Fehlertermen, beispielsweise von (passiven) Kalibrierungsstandards. Eine andere Bezeichnung für ein 3-Term-Kalibrierungsverfahren ist das Reflektometerverfahren nach einem 3-Term-Verfahren. Beispiele für Kalibrierungsstandards sind Open (deutsch Offen - ein offenes Leitungsende bewirkt eine Totalreflexion des gesendeten Signals), Short (deutsch Kurzschluss - ein kurzgeschlossenes Leitungsende bewirkt ebenfalls eine Totalreflexion des gesendeten Signals, jedoch ist die Phase des Signals gegenüber dem Open um 180° gedreht), Match (deutsch Angepasst - das Messtor ist mit seinem Wellenwiderstand abgeschlossen und es treten keine Signalreflexionen auf), Through (deutsch Durchgehend es sind zwei Tore miteinander über eine definierte Verbindungsleitung verbunden), Reflect (allgemeinere Form des Short oder Open, bei dem die genauen Eigenschaften nicht bekannt sein müssen) und Line (ähnlich zu Through). Bevorzugte 3-Term-Kalibrierungsverfahren sind OSM (Open-Source-Match) oder, beispielsweise bei einer mehrtorigen Ausführung zwischen der Kopplungseinheit und der ersten Kalibriereinheit, TRL (Through-Reflect-Line). Diese Kalibrierungsverfahren sind gut zur Ermittlung einer Übertragungsfunktion der mit dem Messsystem verbundenen Kopplungseinheit geeignet.

In weiterer bevorzugter Ausgestaltung ist vorgesehen, dass vor dem Verbinden des ersten Ports der Kopplungseinheit mit der Störquelle der erste Port der Kopplungseinheit mit einer zweiten Kalibriereinheit verbunden und eine absolute Kalibrierung der mit dem Messsystem verbundenen Kopplungseinheit unter Verwendung der zweiten Kalibriereinheit und des Messsystems durchgeführt werden. Ferner werden (vor dem Verbinden des ersten Ports der Kopplungseinheit) das Ergebnis der absoluten Kalibrierung in der Speichereinheit des Messsystems hinterlegt und der erste Port der Kopplungseinheit von der zweiten Kalibriereinheit getrennt. Da die Signalwege und die Kopplungseinheit die tatsächlichen Wellengrößen an der Störquelle bis zu den Ports, also den eigentlichen Messtoren, verfälschen, wird vor der Messung der hochfrequenten Signale in den beiden Lastzuständen mit der gleichen Messanordnung eine absolute Kalibrierung, vorzugsweise eine relative Kalibrierung und eine absolute Kalibrierung in beliebiger Reihenfolge, durchgeführt und die Ergebnisse der absoluten Kalibrierung in der Speichereinheit des Messsystems hinterlegt. Insofern stehen aktualisierte absolute Kalibrierungsparameter zur Verfügung, um die absoluten Wellengrößen der ausgekoppelten hochfrequenten Signale mit einem möglichst geringem systematischen Messfehler bestimmen zu können. Die zweite Kalibriereinheit ist beispielsweise ein Hochfrequenz-Leistungsmesser. Die absolute Kalibrierung wird bevorzugt durchgeführt, indem das Messsystem ein Signal in die Kopplungseinheit einspeist und zugleich die dabei auftretenden Leistungsänderungen durch den HF-Leistungsmesser erfasst werden. Somit werden absolute Leistungswerte und deren absoluten Leistungsänderungen bestimmt (daher absolute Kalibrierung). In bevorzugter Ausgestaltung sind die erste Kalibriereinheit und die zweite Kalibriereinheit als eine (gemeinsame) Einheit ausgestaltet, wobei der HF-Leistungsmesser zugleich als ohmscher Widerstand für die relative Kalibrierung dient.

In weiterer bevorzugter Ausgestaltung ist vorgesehen, dass das jeweilige Verbinden und Trennen der ersten Kalibriereinheit, der zweiten Kalibriereinheit und/oder der Störquelle mit oder von dem ersten Port der Kopplungseinheit selektiv mittels einer Schaltungseinheit erfolgt. Mit anderen Worten ist der erste Port der Kopplungseinheit mit einer Schaltungseinheit verbunden, die einen Schalter umfasst, der ein selektives Durchschalten der Verbindung des ersten Ports mit der ersten Kalibriereinheit, der zweiten Kalibriereinheit und/oder der Störquelle bereitstellen kann. Dies verringert den Aufwand für eine Kalibrierung, da nicht jedes Mal ein manuelles, mechanisches Abklemmen und Anklemmen der Kalibriereinheiten und der Störquelle erforderlich ist. Folglich ist eine sehr einfache In-Situ-Kalibrierung möglich. Selbstverständlich ist zu berücksichtigen, dass der Schalter einen Leitungsweg der Störquelle verlängert und damit ein zusätzliches Zweitor darstellt, das bei der Charakterisierung der Störquelle zu berücksichtigen ist.

In weiterer bevorzugter Ausgestaltung ist vorgesehen, dass das Messsystem die Schaltungseinheit derart ansteuert, dass vor einem jeden Verbinden des ersten Ports der Kopplungseinheit mit der Störquelle, eine absolute und/oder relative Kalibrierung der mit dem Messsystem verbundenen Kopplungseinheit durchgeführt und die jeweiligen Ergebnisse in der Speichereinheit des Messsystems hinterlegt werden. Mit anderen Worten wird vor einer jeden Messung zum Charakterisieren der Störquelle eine Kalibrierung durchgeführt, wodurch der systematische Fehler besonders gering gehalten wird. Dadurch, dass das Messsystem die Kalibrierung im Wesentlichen automatisch durchführt, stellt diese keinen nennenswerten Aufwand oder Zeitverlust für die eigentliche Messung der Störquelle dar. Bevorzugt beträgt eine Zeit zwischen einer oder beiden Kalibrierungen und der Bestimmung der elektrischen Größen der Störquelle weniger als zwei Minuten, vorzugsweise weniger als eine Minute, besonders bevorzugt weniger als zehn Sekunden. Je weniger Zeit zwischen Kalibrierung und Bestimmung der elektrischen Größen der Störquelle vergeht, desto geringer ist der systematische Fehler, zumindest in den meisten Fällen.

In weiterer bevorzugter Ausgestaltung ist vorgesehen, dass das Messsystem eine Quelle zum Erzeugen von sinusodialen und/oder arbiträren Modulationssignalen umfasst oder mit einer derartigen Quelle gekoppelt ist. Grundsätzlich ist die Quelle bevorzugt dazu eingerichtet, das erste und das zweite Modulationssignal zu erzeugen und dem Messsystem zum Einspeisen in die Kopplungseinheit bereitzustellen. Bevorzugt erstrecken sich die sinusodialen Modulationssignale auf sämtliche trigonometrischen Funktionen und nicht ausschließlich auf Sinusfunktionen. Sinusodiale Modulationssignale erlauben eine vergleichsweise einfache Realisierung der Messung der Störemissionen der Störquelle. Die Quelle zum Erzeugen von arbiträren Modulationssignalen umfasst bevorzugt eine Rauschquelle eines aktiven Bauteils, beispielsweise eine rauschende Diode, die jeweils an- und ausgeschaltet wird. Bevorzugt wird das arbiträre Modulationssignal für die oben genannte relative und/oder absolute Kalibrierung verwendet. Arbiträre Modulationssignale hingegen ermöglichen eine Messung der Störemissionen der Störquelle über die gesamte betrachtete Bandbreite der hochfrequenten Signale.

In weiterer bevorzugter Ausgestaltung ist vorgesehen, dass das Messsystem als ein Software-Defined-Radio(SDR)-Messsystem ausgestaltet ist, welches einen Arbiträrgenerator zum Erzeugen von arbiträren Modulationssignalen umfasst. Unter dem Begriff SDR sind Konzepte für HF-Sender und -Empfänger zusammengefasst, bei denen kleinere oder größere Anteile der Signalverarbeitung mit Software verwirklicht werden. Die Hardware eines SDR-Messsystems umfasst zumindest ein Sender- und/oder Empfängermodul, jeweils einen D/A- und/oder A/D-Umsetzer und einer dazwischenliegenden, softwarebasierten digitalen Signalverarbeitung. Beispielsweise umfasst das SDR-Messsystem das Empfängermodul und den A/D-Umsetzer. Vorteilhaft lässt sich hierdurch die Frequenz des Modulationssignals und die der Empfangssignale bequem aufeinander (per Software) abstimmen. Die Signalverarbeitung ist dabei üblicherweise komplex, in dem Sinne, dass ein Signalpfad aus einem Paar von zwei parallel geführten reellen Zahlenfolgen besteht (I/Q-Signal). SDR-Topologien bieten eine hohe Messdynamik und haben ferner den Vorteil, dass auch Arbiträrgeneratoren im Konzept enthalten sind, die üblicherweise für die Aussendung von Funksignalen gedacht sind. Insofern ist eine einfache Realisierung des Messsystems möglich. Bevorzugt wird das von dem Arbiträrgenerator erzeugte arbiträre Modulationssignal für die oben genannte relative und/oder absolute Kalibrierung verwendet.

In weiterer bevorzugter Ausgestaltung ist vorgesehen, dass die Kopplungseinheit in Form eines Diplexers ausgestaltet ist. Hierbei wird ein Gleichspannungssignal von einer Spannungsquelle, beispielsweise eine DC-Quelle (Gleichspannungsquelle), zur elektrischen Versorgung der Störquelle in einer von dem zweiten Port entkoppelten Leitung des Diplexers eingespeist. In der Praxis sind Versorgungsleitungen zum Versorgen der elektronischen Komponenten erforderlich. Dabei sind die auftretenden Störungen an den Versorgungsleitungen meist am Größten. Insofern erlaubt die Verwendung eines Diplexers, dass Störemissionen einer mit einer Versorgungsleitung verbundenen Störquelle charakterisiert werden können, sodass besonders praxisnahe Verhaltensmodelle erstellt werden können.

In weiterer bevorzugter Ausgestaltung ist vorgesehen, dass das erste und/oder das zweite Modulationssignal eine Signaldauer von bis zu 1 s, bevorzugt bis zu 50 ms, vorzugsweise bis zu 10 ms, besonders bevorzugt bis zu 5 ms oder bis zu 2 ms, aufweisen. Mit anderen Worten wird das erste und/oder das zweite Modulationssignal jeweils derart kurz ausgestaltet, dass auch besonders schnelllebige und wechselhafte Dynamiken und deren Störemissionen, die beispielweise bereits nach 10 ms eine veränderte Dynamik aufzeigen, aufgelöst und charakterisiert werden können. Vorteilhaft können Störemissionen besonders genau charakterisiert werden.

In weiterer bevorzugter Ausgestaltung ist vorgesehen, dass die Kopplungseinheit mindestens einen weiteren Port zum Verbinden mit einer weiteren elektrischen oder elektronischen Störquelle umfasst. Ferner führt das Messsystem eine Mehrleitermessung an dem ersten Port und dem weiteren Port zur Bestimmung einer Störquellenspannung, eines Störquellenstroms und/oder einer Störleistungswelle der jeweiligen Störquelle durch. Mit anderen Worten wird statt eines Störsignals auf einer Leitung gegen das Bezugspotenzial auch Mehrleitermessungen mit mehrtorigen Messanordnungen durchgeführt. Dies erfolgt bevorzugt phasenkohärent, so dass die Phasenbeziehungen zwischen Strom und Spannung zu den jeweils benachbarten Leitern erfasst werden können. Mehrleitermessungen haben Vorteile bei der Kalibrierung der Messanordnung, da Selbstkalibrierverfahren mit geringeren Voraussetzungen als bei einem Einzelleitermessverfahren verwendbar sind. Beispielsweise kann ein TLR-Kalibrierungsverfahren durchgeführt werden, bei welchem mehr Freiheitsgrade zur Verfügung stehen, da beispielsweise die Reflektion an den jeweiligen Ports nicht zwingend einen Wert von eins betragen muss. Vorteilhaft wird die Durchführung der Kalibrierung weiter vereinfacht.

In weiterer bevorzugter Ausgestaltung ist vorgesehen, dass in beide Richtungen durch den ersten Port und/oder den weiteren Port der Kopplungseinheit laufende Anteile der hochfrequenten Signale in den beiden Lastzuständen mittels Homodynempfängern, Heterodynempfängern und/oder einer Zeitbereichsmesseinrichtung des Messsystems erfasst und basierend darauf die jeweiligen absoluten Wellengrößen bestimmt werden. Eine Zeitbereichsmessung erfolgt beispielsweise mittels eines Oszilloskops oder eines Digitizers. In der Regel weisen Störsignale einen starken Frequenzgang auf, so dass meist gleichzeitig große und kleine Signalamplituden mit ausreichender Dynamik erfasst werden müssen. Hierfür ist die Verwendung von Homodyn- und/oder Heterodynempfängern zusammen mit einem oder mehreren zusätzlichen Bandfiltern bevorzugt. Durch zusätzliche Bandfilter kann die Störung schrittweise durch Messung eines kleinen Frequenzausschnitts betrachtet und eine Anhebung oder Absenkung der Signalstärke über variable Vorverstärker durchgeführt werden, bevor das Signal abgetastet wird. Damit kann die Großsignalfestigkeit weiter erhöht werden. Insgesamt wird durch die Messung eines komplexen Basisbands eine bessere Messdynamik erreicht.

Ein weiterer Aspekt der Erfindung betrifft eine Messanordnung zum Bestimmen von elektrischen Größen für ein Verhaltensmodell einer elektrischen oder elektronischen Störquelle, vorzugsweise ein EMV-Verhaltensmodell für die Simulation von elektromagnetischen Störemissionen von Komponenten, beispielsweise eine Komponente eines Kraftfahrzeugs, wie ein Elektromotor, eine Zündkerze, eine Radioempfangseinheit und dergleichen, um ein Verhalten der Komponente in einem realen System vorherzusagen. Die Messanordnung umfasst ein Messsystem und eine Kopplungseinheit mit einem ersten Port zum Verbinden der Störquelle mit einer Last über eine verbindende Leitung und einem zweiten Port, über welchen die Kopplungseinheit mit dem Messsystem verbunden ist. Das Messsystem umfasst eine Speichereinheit mit hinterlegten Ergebnissen einer relativen und einer absoluten Kalibrierung der mit dem Messsystem verbundenen Kopplungseinheit und einen Prozessor. Der Prozessor ist dazu eingerichtet, ein erstes Modulationssignal zu erzeugen und dieses zum Herstellen eines ersten Lastzustands in die Kopplungseinheit einzuspeisen und in dem ersten Lastzustand an dem ersten Port anliegende hochfrequente Signale zu empfangen. Der Prozessor ist ferner dazu eingerichtet, ein von dem ersten Modulationssignal unterschiedliches zweites Modulationssignal zu erzeugen und dieses zum Herstellen eines zweiten Lastzustands in die Kopplungseinheit einzuspeisen und in dem zweiten Lastzustand an dem ersten Port anliegende hochfrequente Signale zu empfangen. Der Prozessor ist ferner dazu eingerichtet, absolute Wellengrößen aus den jeweils in den beiden Lastzuständen empfangenen hochfrequenten Signalen basierend auf den in der Speichereinheit hinterlegten Ergebnissen zu ermitteln und Ströme und Spannungen in den beiden Lastzuständen basierend auf den absoluten Wellengrößen zu bestimmen. Ebenfalls ist der Prozessor dazu eingerichtet, ausgehend von einem Verhältnis einer durch die zwei Lastzustände hervorgerufenen Spannungsdifferenz zu einer hervorgerufenen Stromdifferenz eine Impedanz zu bestimmen und eine Störquellenspannung, einen Störquellenstrom und/oder eine Störleistungswelle basierend auf der Impedanz, und bevorzugt den Messdaten aus den beiden Lastzuständen, zu bestimmen. Im Wesentlichen ist der Prozessor also zum Durchführen des oben beschriebenen Verfahrens eingerichtet, soweit die Verfahrensschritte den Prozessor beziehungsweise das Messsystem betreffen. Die mit dem Verfahren erzielten Vorteile können in analoger Weise mit der Messanordnung erzielt werden. Die offenbarten Merkmalskombinationen des Verfahrens sind analog auf die Messanordnung übertragbar. Auf eine wiederholende Beschreibung der Merkmale und Vorteile wird daher verzichtet.

Die einzelnen Verfahrensschritte des erfindungsgemäßen Verfahrens sind ferner bevorzugt als ein oder mehrere Prozesse ausgebildet, die auf einem oder mehreren Prozessoren in einem oder mehreren elektronischen Rechengeräten laufen und beim Ausführen von einem oder mehreren Computerprogrammen erzeugt werden. Die Rechengeräte sind dabei bevorzugt dazu ausgebildet, mit anderen Komponenten zusammenzuarbeiten, um die hierin beschriebenen Funktionalitäten zu verwirklichen. Ebenso bevorzugt ist das Messsystem als eine zentrale (einteilige) oder als eine dezentrale (mehrteilige) Komponente ausgebildet.

Dem Fachmann ist ferner ersichtlich, dass die Funktionalitäten von mehreren Computern (Datenverarbeitungsgeräten) kombiniert oder in einem einzigen Gerät kombiniert sein können oder dass die Funktionalität von einem bestimmten Datenverarbeitungsgerät auf eine Vielzahl von Geräten verteilt vorliegen kann, um die Schritte des erfindungsgemäßen Verfahrens auszuführen, ohne vom erfindungsgemäßen Verfahren abzuweichen.

Ein weiterer Aspekt der Erfindung betrifft ein Computerprogramm, umfassend Befehle, die bei der Ausführung des Programms durch einen Computer, wie beispielsweise einem Prozessor des Messsystems, diesen veranlassen, das hierin genannte Verfahren durchzuführen. Die Anweisungen des Computerprogramms sind bevorzugt in einem Speicher abgelegt, wie beispielsweise einem RAM-Element. Die Computerprogramme können jedoch auch in einem nicht-flüchtigen Speichermedium, wie beispielsweise einer CD-ROM, einem Flash-Speicher oder dergleichen, abgelegt sein.

Ein weiterer Aspekt der Erfindung betrifft ein maschinenlesbares Speichermedium, auf welchem das hierin offenbarte Computerprogramm hinterlegt ist.

Weitere bevorzugte Ausgestaltungen der Erfindung ergeben sich aus den übrigen, in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:

Figur 1   eine schematische Darstellung eines Schaltdiagramms zur Bestimmung einer Störquelle mittels aktiver Modulation,

Figur 2   eine schematische Darstellung einer Messanordnung zum Bestimmen von elektrischen Größen für ein Verhaltensmodell einer elektrischen oder elektronischen Störquelle gemäß einer ersten Ausführungsform,

Figur 3   eine schematische Darstellung einer Messanordnung zum Bestimmen von elektrischen Größen für ein Verhaltensmodell einer elektrischen oder elektronischen Störquelle gemäß einer zweiten Ausführungsform und

Figur 4   eine schematische Darstellung eines Verfahrens zum Bestimmen von elektrischen Größen für ein Verhaltensmodell einer elektrischen oder elektronischen Störquelle gemäß einer Durchführungsform.

Es werden nun detaillierte Ausführungsformen beschrieben, die beispielhaft in den beigefügten Zeichnungen dargestellt sind. Die Wirkungen und Merkmale dieser Ausführungsformen werden unter Bezugnahme auf die beigefügten Zeichnungen beschrieben. In den Zeichnungen bezeichnen gleiche Bezugsziffern gleiche Elemente und auf redundante Beschreibungen wird verzichtet. Die vorliegende Offenbarung kann in verschiedenen Formen verwirklicht werden und ist nicht so zu verstehen, dass sie nur auf die hier dargestellten Ausführungsformen beschränkt ist. Vielmehr sind diese Ausführungsformen Beispiele, damit diese Offenbarung gründlich und vollständig ist und dem Fachmann die Aspekte und Merkmale der vorliegenden Offenbarung vollständig vermittelt.

Verfahren, Elemente und Techniken, die für den Fachmann zum vollständigen Verständnis der Aspekte und Merkmale der vorliegenden Offenbarung nicht notwendig sind, werden daher gegebenenfalls nicht beschrieben. In den Zeichnungen können die relativen Größen von Elementen, Schichten und Bereichen zur Verdeutlichung übertrieben dargestellt sein.

Wie hierin verwendet, schließt der Begriff "und/oder" alle Kombinationen von einem oder mehreren der aufgeführten Elemente ein. Ferner bezieht sich die Verwendung von "kann" bei der Beschreibung von Ausführungsformen der vorliegenden Offenbarung auf "eine oder mehrere Ausführungsformen der vorliegenden Offenbarung". **In** der folgenden Beschreibung von Ausführungsformen können die Begriffe in der Einzahl auch die Mehrzahl umfassen, sofern aus dem Kontext nicht eindeutig etwas anderes hervorgeht.

Obwohl die Begriffe "erste" und "zweite" zur Beschreibung verschiedener Elemente verwendet werden, sollten diese Elemente nicht durch diese Begriffe eingeschränkt werden. Diese Begriffe werden nur verwendet, um ein Element von einem anderen Element zu unterscheiden. So kann beispielsweise ein erstes Element als zweites Element bezeichnet werden, und ebenso kann ein zweites Element als erstes Element bezeichnet werden, ohne dass dies vom Anwendungsbereich der vorliegenden Offenbarung abweicht. Ausdrücke wie "mindestens eines von", wenn sie einer Liste von Elementen vorangestellt werden, modifizieren die gesamte Liste und nicht nur die einzelnen Elemente der Liste.

Begriffe wie "im Wesentlichen", "ungefähr" und ähnliche werden als Annäherungsbegriffe und nicht als Gradangaben verwendet und sollen die inhärenten Abweichungen bei gemessenen oder berechneten Werten berücksichtigen, die von Fachleuten erkannt werden. Wenn der Begriff "im Wesentlichen" in Verbindung mit einem Merkmal verwendet wird, das durch einen numerischen Wert ausgedrückt werden kann, bezeichnet der Begriff "im Wesentlichen" einen Bereich von zumindest +/- 5 % des Wertes, der auf den Wert zentriert ist.

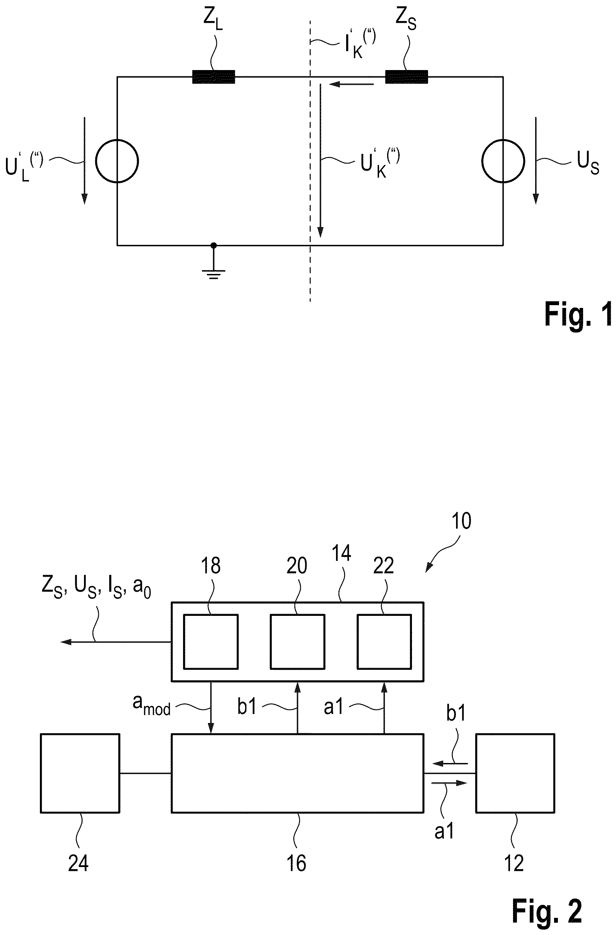

Figur 1 zeigt eine schematische Darstellung eines Schaltdiagramms zur Bestimmung einer Störquelle mittels einer aktiven Modulation der anliegenden Last $U_L'^{('')}$. Ziel gemäß der zugrundliegenden Theorie ist die Bestimmung der komplexen Quellspannung $U_S$ und der komplexen Impedanz $Z_S$ eines aktiven Zweipols (siehe Figur 1, rechte Schaltungsseite). Die Bestimmung erfolgt durch eine Messung der Größen $U_K$ und $I_K$ bei zwei Lastzuständen der Modulationsquelle $U_L$. Die beiden Zustände werden durch die Hochstellung ' und " gekennzeichnet. Es ergeben sich die folgende Gleichungen (1) und (2), aus denen die gewünschten Größen der komplexen Quellspannung $U_S$ und der komplexen Impedanz $Z_S$ gewonnen werden können:

$$U_S = U_K' + I_K' \cdot Z_S \qquad (1)$$

$$Z_S = \frac{U_K' - U_K''}{I_K'' - I_K'} \qquad (2)$$

Die Herausforderung in der Messung besteht einerseits in der Herstellung der beiden Lastzustände und andererseits der Messungen der Ströme und Spannungen an der Störquelle beziehungsweise dem Prüfling.

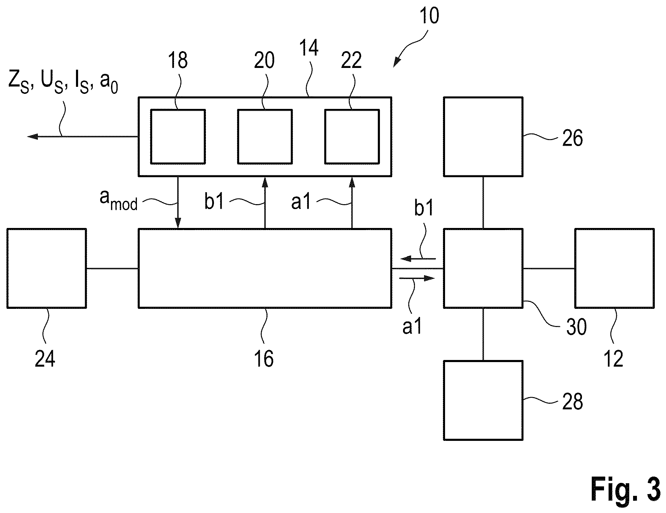

Eine Messanordnung 10, mit welcher die Messung der Größen $U_K$ und $I_K$ bei zwei Lastzuständen $U_L'^{('')}$ möglich ist und welche daraus die komplexe Quellspannung $U_S$ und die komplexe Impedanz $Z_S$ ermitteln kann, ist in den Figuren 2 und 3 dargestellt. Figuren 2 und 3 zeigen schematische Darstellungen einer Messanordnung 10 zum Bestimmen von elektrischen Größen für ein Verhaltensmodell einer elektrischen oder elektronischen Störquelle 12 gemäß einer ersten und einer zweiten Ausführungsform, vorzugsweise ein EMV-Verhaltensmodell für die Simulation von elektromagnetischen Störemissionen von Komponenten, beispielsweise eine Komponente eines Kraftfahrzeugs, wie ein Elektromotor, eine Zündkerze, eine Radioempfangseinheit und dergleichen, um ein Verhalten der Komponente in einem realen System vorherzusagen.

In der ersten Ausführungsform umfasst die Messanordnung 10 ein Messsystem 14 und eine Kopplungseinheit 16. Die Kopplungseinheit 16 umfasst einen ersten Port zum Verbinden der Störquelle 12 mit einer Last über eine verbindende Leitung und einem zweiten Port, über welchen die Kopplungseinheit 16 mit dem Messsystem 14 verbunden ist. Der zweite Port dient grundsätzlich der Einspeisung von Modulationssignalen $a_{mod}$ von dem Messsystem 14 in die Kopplungseinheit 16. Durch die eingespeisten Modulationssignale $a_{mod}$ wird eine Last $U_L$ angelegt.

Die Schnittstelle der Größen $U_K$ und $I_K$ (vgl. Figur 1) entspricht dem ersten Port mit den Wellengrößen a1 und b1. Die Wellengröße a1 bezieht sich auf einen ersten Anteil eines ersten HF-Signals, welches ausgehend von der Last in Richtung der Störquelle 12 durch die Kopplungseinheit 16 läuft, und die Wellengröße b1 bezieht sich auf einen zweiten Anteil eines zweiten HF-Signals, welches ausgehend von der Störquelle 12 in Richtung der Last durch die Kopplungseinheit 16 läuft.

In der dargestellten Ausführungsform umfasst die Kopplungseinheit 16 zwei weitere Ports, nämlich einen dritten und einen vierten Port, mit welchem die Kopplungseinheit 16 ebenfalls mit dem Messsystem 14 verbunden ist. Der dritte und vierte Port dienen jeweils zum Auskoppeln der an dem ersten Port auftretenden Wellengrößen a1 und b1 der HF-Signale. Durch die Auskopplung der HF-Signale wird die Messung der Wellengrößen a1 und b1 am ersten Port durch das Messsystem 14 ermöglicht. Das Messsystem 14 ist dazu eingerichtet, die Wellengrößen a1 und b1 phasenkohärent zu messen und Modulationssignale $a_{mod}$ zu erzeugen und in die Kopplungseinheit 16 einzuspeisen.

Das Messsystem 14 umfasst eine Speichereinheit 18 mit hinterlegten Ergebnissen einer relativen und einer absoluten Kalibrierung der mit dem Messsystem 14 verbundenen Kopplungseinheit 16, einen Prozessor 20 und eine Quelle 22 zum Erzeugen von den Modulationssignalen $a_{mod}$.

In der Speichereinheit 18 sind Kalibrierparameter hinterlegt, mit denen eine Übertragungsfunktion der Kopplungseinheit 16 in einem mit dem Messsystem 14 verbundenen Zustand abgebildet wird. Anders gesagt, werden bei der Berechnung der absoluten Wellengrößen a1 und b1 systematische Fehler vermieden, die dadurch bedingt sind, dass die Kalibrierung mit einem anderen Messsystem erfolgt, als das Messsystem zur (späteren) Messung der Störquelle, wie es beispielsweise bei der Verwendung eines Netzwerkanalysators der Fall ist.

Der Prozessor 20 ist dazu eingerichtet, ein erstes Modulationssignal $a'_{mod}$ zu erzeugen und dieses zum Herstellen eines ersten Lastzustands $U'_L$ in die Kopplungseinheit 16 einzuspeisen und in dem ersten Lastzustand $U'_L$ an dem ersten Port anliegende HF-Signale zu empfangen. Der Prozessor 20 ist ferner dazu eingerichtet, ein von dem ersten Modulationssignal $a'_{mod}$ unterschiedliches zweites Modulationssignal $a''_{mod}$ zu erzeugen und dieses zum Herstellen eines zweiten Lastzustands $U''_L$ in die Kopplungseinheit 16 einzuspeisen und in dem zweiten Lastzustand $U''_L$ an dem ersten Port anliegende HF-Signale zu empfangen. Der Prozessor 20 ist ebenfalls dazu eingerichtet, die absolute Wellengrößen a1 und b1 aus den jeweils in den beiden Lastzuständen $U_L'^{(\prime\prime)}$ empfangenen HF-Signalen basierend auf den in der Speichereinheit 18 hinterlegten Ergebnissen zu ermitteln und Ströme $I_K'^{(\prime\prime)}$ und Spannungen $U_K'^{(\prime\prime)}$ in den beiden Lastzuständen $U_L'^{(\prime\prime)}$ basierend auf den absoluten Wellengrößen a1 und b1 zu bestimmen. Ferner ist der Prozessor 20 dazu eingerichtet, ausgehend von einem Verhältnis einer durch die zwei Lastzustände $U_L'^{(\prime\prime)}$ hervorgerufenen Spannungsdifferenz zu einer hervorgerufenen Stromdifferenz die Impedanz $Z_S$ gemäß der Gleichung (2) zu bestimmen und eine Störquellenspannung $U_S$ basierend auf der Impedanz $Z_S$ gemäß der Gleichung (1) zu bestimmen. Zusätzlich oder alternativ ist der Prozessor 20 dazu eingerichtet, einen Störquellenstrom $I_s$ und/oder eine Störleistungswelle $a_0$ basierend auf der Impedanz $Z_S$ zu bestimmen.

Die Quelle 22 zum Erzeugen von den Modulationssignalen $a_{mod}$ ist dazu eingerichtet, das erste und das zweite Modulationssignal $a_{mod}'^{(\prime\prime)}$ zu erzeugen und dem Messsystem 14 zum Einspeisen in die Kopplungseinheit 16 bereitzustellen. Beispielsweise ist die Quelle 22 zum Erzeugen von sinusodialen und/oder arbiträren Modulationssignalen $a_{mod}$ eingerichtet. Sinusodiale Modulationssignale erlauben eine vergleichsweise einfache Realisierung der Messung der Störemissionen der Störquelle 12. Arbiträre Modulationssignale hingegen ermöglichen eine besonders exakte Messung der Störemissionen der Störquelle 12 über die gesamte betrachtete Bandbreite der HF-Signale.

In der in Figur 2 gezeigten (ersten) Ausführungsform ist die Kopplungseinheit 16 in Gestalt eines Diplexers ausgestaltet, ohne hierauf beschränkt zu sein. Ein weiterer Port der Kopplungseinheit 16 ist hierbei mit einer Spannungsquelle 24 verbunden. Die Spannungsquelle 24 ist im vorliegenden Beispiel eine Gleichspannungsquelle (DC-Quelle). Die Spannungsquelle 24 dient zur elektrischen Versorgung der Störquelle 12. Hierzu wird über den weiteren Port ein Gleichspannungssignal in einer von den zweiten bis vierten Ports entkoppelten Leitung des Diplexers eingespeist. In der Praxis sind Versorgungsleitungen zum Versorgen der elektronischen Komponenten (Störquellen 12) erforderlich. Dabei sind die auftretenden Störungen an den Versorgungsleitungen meist am Größten. Insofern erlaubt die Verwendung eines Diplexers, dass auch Störemissionen einer mit einer Versorgungsleitung verbundenen Störquelle 12 charakterisiert werden können, sodass besonders praxisnahe Verhaltensmodelle erstellt werden können.

Da Signalwege und die Koppeleinheit 16 die tatsächlichen Wellengrößen a1 und b1 an der Störquelle 12 bis zu den eigentlichen Messtoren (Ports) verfälschen, wird bevorzugt vor der Messung mit der gleichen Messanordnung 10 eine 3-Term Kalibrierung sowie eine Absolutleistungskalibrierung durchgeführt. Dafür sind beispielsweise drei passive Kalibrierstandards sowie ein HF-Leistungsmesser erforderlich, die statt der Störquelle 12 an dem ersten Port der Kopplungseinheit 16 angeschlossen werden. Um ein manuelles, mechanisches Abklemmen und Anklemmen der von Kalibriereinheiten und der Störquelle 12 zu verhindern, umfasst die in Figur 3 gezeigte Messanordnung 10 ferner eine Schaltungseinheit 30, welche mit dem ersten Port der Kopplungseinheit 16 verbunden ist.

Im Hinblick auf die Messanordnung 10 gemäß der zweiten Ausführungsform wird auf eine in Bezug auf die erste Ausführungsform der Messanordnung 10 wiederholende Beschreibung der Merkmale verzichtet und im Nachfolgenden lediglich die Unterschiede zwischen der ersten und zweiten Ausführungsform der Messanordnung 10 näher erläutert. Die Schaltungseinheit 30 ist mit einer ersten Kalibriereinheit 26, einer zweiten Kalibriereinheit 28 und der Störquelle 12 verbunden. Die Schaltungseinheit 30 umfasst einen Schalter, der ein selektives Durchschalten der Verbindung des ersten Ports mit der ersten Kalibriereinheit 26, der zweiten Kalibriereinheit 28 oder der Störquelle 12 bereitstellen kann. Die erste Kalibriereinheit 26 ist bevorzugt zum Durchführen einer relativen Kalibrierung, beispielsweise der 3-Term Kalibrierung, eingerichtet. Die zweite Kalibriereinheit 28 ist bevorzugt zum Durchführen einer absoluten Kalibrierung, beispielsweise einer Absolutleistungskalibrierung, eingerichtet.

Bevorzugt ist das Messsystem 14 dazu eingerichtet, die Schaltungseinheit 30 derart anzusteuern, dass vor einer jeden Messung (also einem jeden Verbinden des ersten Ports der Kopplungseinheit 16 mit der Störquelle 12), eine relative Kalibrierung durch Anschließen (und Trennen) der ersten Kalibriereinheit 26 und eine absolute Kalibrierung durch Anschließen (und Trennen) der zweiten Kalibriereinheit 28 mit dem ersten Port der Kopplungseinheit 16 durchgeführt und die jeweiligen Ergebnisse in der Speichereinheit 18 des Messsystems 14 hinterlegt werden. Mit anderen Worten wird vor einer jeden Messung zum Charakterisieren der Störquelle 12 eine Kalibrierung durchgeführt, wodurch der systematische Fehler besonders gering gehalten wird. Dadurch, dass das Messsystem 14 die Kalibrierung im Wesentlichen automatisch durchführen kann, stellt diese keinen nennenswerten Aufwand oder Zeitverlust für die eigentliche Messung der Störquelle 12 dar.

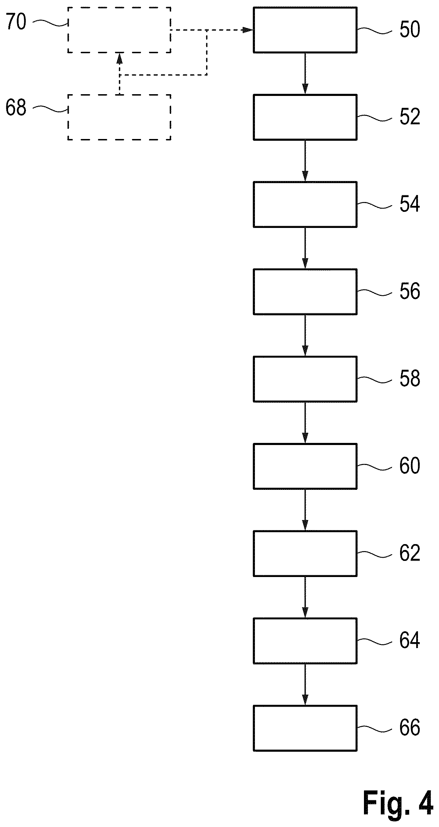

Figur 4 zeigt eine schematische Darstellung eines Verfahrens zum Bestimmen von elektrischen Größen für ein Verhaltensmodell einer elektrischen oder elektronischen Störquelle 12 gemäß einer Durchführungsform. Das Verfahren kann insbesondere mit einem der hierin genannten Messanordnungen 10 durchgeführt werden.

Gemäß einem ersten Verfahrensschritt 50 wird ein erster Port einer Kopplungseinheit 16 mit der Störquelle 12 verbunden. Mit anderen Worten wird ein auf seine Störemission zu überprüfender Prüfling, also eine elektrische oder elektronische Komponente, bevorzugt eine Komponente eines Fahrzeugs, insbesondere eines Kraftfahrzeugs, an die Kopplungseinheit 16 angeschlossen.

In einem zweiten Schritt des Verfahrens 52 wird ein erster Lastzustand hergestellt. Dies erfolgt durch Einspeisen eines ersten Modulationssignals in die Kopplungseinheit 16 durch ein mit einem zweiten Port der Kopplungseinheit 16 verbundenes Messsystem 14. Von dem Messsystem 14 wird das (erste) Modulationssignal über den zweiten Port in die Kopplungseinheit 16 eingespeist und gelangt von dort über den ersten Port der Kopplungseinheit 16 zu der Störquelle 12. Durch das Modulationssignal hervorgerufene Dynamiken in der Störquelle 12 gelangen Störemissionen der Störquelle 12 und/oder Streuerscheinungen an dem ersten Port in Gestalt eines oder mehrerer HF-Signale über den ersten Port zurück in die Kopplungseinheit 16.

In einem dritten Verfahrensschritt 54 werden in dem ersten Lastzustand an dem ersten Port anliegende HF-Signale (durch die Kopplungseinheit 16) ausgekoppelt und an das Messsystem 14 weitergeleitet. Bevorzugt werden ein erster Anteil eines ersten HF-Signals, welches ausgehend von der Last in Richtung der Störquelle 12 durch die Kopplungseinheit 16 läuft, und/oder ein zweiter Anteil eines zweiten HF-Signals, welches ausgehend von der Störquelle 12 in Richtung der Last durch die Kopplungseinheit 16 läuft, ausgekoppelt. Durch das Auskoppeln und Weiterleiten der beiden Anteile der HF-Signale (in dem ersten Lastzustand) wird eine Messung der Wellengrößen der HF Signale an dem ersten Port durch das Messsystem 14 ermöglicht.

Gemäß einem vierten Schritt des Verfahrens 56 wird ein zweiter Lastzustand hergestellt. Dies erfolgt durch Einspeisen eines von dem ersten Modulationssignal unterschiedlichen zweiten Modulationssignals in die Kopplungseinheit 16 durch das Messsystem 14. Analog zu dem ersten Modulationssignal wird das zweite Modulationssignal von dem Messsystem 14 über den zweiten Port in die Kopplungseinheit 16 eingespeist und gelangt von dort über den ersten Port der Kopplungseinheit 16 zu der Störquelle 12. Erneut gelangen durch die durch das (zweite) Modulationssignal verursachte Dynamiken in der Störquelle 12 verursachte Störemissionen der Störquelle 12 und/oder Streuerscheinungen an dem ersten Port in Gestalt eines oder mehrerer HF-Signale über den ersten Port zurück in die Kopplungseinheit 16.

In einem fünften Verfahrensschritt 58 werden in dem zweiten Lastzustand an dem ersten Port anliegende hochfrequente Signale (durch die Kopplungseinheit 16) ausgekoppelt und an das Messsystem 14 weitergeleitet. Bevorzugt werden ein dritter Anteil eines dritten HF-Signals, welches ausgehend von der Last in Richtung der Störquelle 12 durch die Kopplungseinheit 16 läuft, und/oder ein vierter Anteil eines vierten HF-Signals, welches ausgehend von der Störquelle 12 in Richtung der Last durch die Kopplungseinheit 16 läuft, ausgekoppelt. Durch das Auskoppeln und Weiterleiten der beiden Anteile der HF-Signale (in dem zweiten Lastzustand) wird analog eine Messung der Wellengrößen der HF-Signale an dem ersten Port durch das Messsystem 14 ermöglicht, dieses Mal jedoch in dem unterschiedlichen zweiten Lastzustand. Mit anderen Worten liegen dem Messsystem 14 entsprechende HF-Signale der Störquelle 12 bei zwei unterschiedlichen Lastzuständen vor.

Ferner werden absolute Wellengrößen aus den jeweils in den beiden Lastzuständen ausgekoppelten hochfrequenten Signalen (im Frequenzbereich) ermittelt (sechster Verfahrensschritt 60). Die erfassten Anteile der hochfrequenten Signale werden bevorzugt mittels einer mathematischen Operation in den Frequenzbereich überführt, beispielsweise mittels einer inversen Fouriertransformation. Das Ermitteln der Wellengrößen erfolgt basierend auf in einer Speichereinheit 18 des Messsystems hinterlegten Ergebnissen einer relativen und einer absoluten Kalibrierung der mit dem Messsystem 14 verbundenen Kopplungseinheit 16 (vgl. obige Ausführungen). Die Wellengrößen der jeweils ausgekoppelten hochfrequenten Signale der beiden Lastzustände werden bevorzugt über eine vorgegebene Bandbreite durch das Messsystem 14 phasenkohärent erfasst.

In einem siebten Verfahrensschritt 62 werden Ströme und Spannungen in den beiden Lastzuständen basierend auf den absoluten Wellengrößen bestimmt. Mit anderen Worten wird im Frequenzbereich mittels einer mathematischen Operation eine elektrische Spannung und ein elektrischer Strom an dem ersten Port der Kopplungseinheit 16 in jedem der beiden Lastzustände ermittelt.

In einem achten Schritt des Verfahrens 64 wird eine Impedanz, ausgehend von einem Verhältnis einer durch die zwei Lastzustände hervorgerufenen Spannungsdifferenz, zu einer hervorgerufenen Stromdifferenz gemäß der Formel (2) bestimmt.

Ferner wird eine Störquellenspannung, ein Störquellenstrom und/oder eine Störleistungswelle (der Störquelle 12) basierend auf der Impedanz bestimmt (neunter Verfahrensschritt 66). Die Störquellenspannung, der Störquellenstrom und die Störleistungswelle stellen die Wesentlichen elektrischen Größen für das Verhaltensmodell der elektrischen oder elektronischen Störquelle 12 dar.

Erfindungsgemäß erfolgt demnach eine Bestimmung der elektrischen Größen einer Störquelle 12 mittels einer aktiven Lastmodulation, welche durch die beiden Modulationssignale zum Herstellen der unterschiedlichen Lastzustände erfolgt. Die aktive Lastmodulation bietet eine hohe Flexibilität hinsichtlich der (gewünschten) Lastzustände. Die Modulationssignale können zeitlich und spektral im Wesentlichen beliebig gestaltet werden, wodurch zeitlich und spektral optimierte Modulationen der Lasten möglich sind, um die Störquelle 12 optimaler zu charakterisieren. Eine manuelle Veränderung der Lasten mittels Schalten von passiven Impedanzen erlaubt keine derartige Flexibilität. Aber auch bei der Fehlerkorrektur mit einem Netzwerkanalysator treten zusätzliche systematische Fehler auf, die dadurch bedingt sind, dass die Kalibrierung mit einem anderen Messsystem erfolgt, als das Messsystem zur (späteren) Messung der Störquelle 12. Da die Kalibrierung und zugleich die Messung mit dem Messsystem 14 erfolgen, werden derartige systematische Fehler ebenfalls vermieden. Mit anderen Worten werden erfindungsgemäß die Vorteile einer kalibrierten Messung mit denen einer aktiven Modulation der Störquelle 12 kombiniert, sodass ein auftretender Messfehler verringert wird. Dadurch, dass das mit der Kopplungseinheit 16 verbundene Messsystem 14 ein für die Kalibrierung erforderliches Signal bereitstellen kann, ist erfindungsgemäß eine In-Situ-Kalibrierung über die gesamte Messanordnung 10 aus Kopplungseinheit 16 und Messsystem 14 möglich.

In einem ersten optionalen Verfahrensschritt 68 wird vor dem Verbinden 50 des ersten Ports der Kopplungseinheit 16 mit der Störquelle 12 der erste Port der Kopplungseinheit 16 mit einer ersten Kalibriereinheit 26 verbunden und eine relative Kalibrierung der mit dem Messsystem 14 verbundenen Kopplungseinheit 16 unter Verwendung der ersten Kalibriereinheit 26 und des Messsystems 14 durchgeführt. Ferner werden (vor dem Verbinden 50 des ersten Ports der Kopplungseinheit 16) das Ergebnis der relativen Kalibrierung in der Speichereinheit 18 des Messsystems 14 hinterlegt und der erste Port der Kopplungseinheit 16 von der ersten Kalibriereinheit 26 getrennt. Insofern stehen aktualisierte relative Kalibrierungsparameter zur Verfügung, um die absoluten Wellengrößen der ausgekoppelten hochfrequenten Signale mit einem möglichst geringem systematischen Messfehler bestimmen zu können. Die erste Kalibriereinheit 26 ist beispielsweise ein ohmscher Widerstand, vorzugsweise mit 50 Ohm. Die relative Kalibrierung wird bevorzugt durchgeführt, indem das Messsystem 14 ein Signal in die Kopplungseinheit 16 einspeist und zugleich die dabei auftretenden Signaländerungen durch einen Messempfänger, beispielsweise ein Oszilloskop oder ein Digitizer, im Messsystem 14 erfasst werden. Damit lässt sich die Messung von Sende- und Empfangssignal als relative Messung gestalten und die Messwerte zueinander in Relation setzen.

Gemäß einem zweiten optionalen Verfahrensschritt 70 werden (ebenfalls) vor dem Verbinden 50 des ersten Ports der Kopplungseinheit 16 mit der Störquelle 12 der erste Port der Kopplungseinheit 16 mit einer zweiten Kalibriereinheit 28 verbunden und eine absolute Kalibrierung der mit dem Messsystem 14 verbundenen Kopplungseinheit 16 unter Verwendung der zweiten Kalibriereinheit 28 und des Messsystems 14 durchgeführt. Ferner werden (vor dem Verbinden 50 des ersten Ports der Kopplungseinheit 16) das Ergebnis der absoluten Kalibrierung in der Speichereinheit 18 des Messsystems 14 hinterlegt und der erste Port der Kopplungseinheit 16 von der zweiten Kalibriereinheit 28 getrennt. Insofern stehen aktualisierte absolute Kalibrierungsparameter zur Verfügung, um die absoluten Wellengrößen der ausgekoppelten hochfrequenten Signale mit einem möglichst geringem systematischen Messfehler bestimmen zu können. Die zweite Kalibriereinheit 28 ist beispielsweise ein HF-Leistungsmesser. Die absolute Kalibrierung wird bevorzugt durchgeführt, indem das Messsystem 14 ein Signal in die Kopplungseinheit 26 einspeist und zugleich die dabei auftretenden Leistungsänderungen durch den HF-Leistungsmesser erfasst werden. Somit werden absolute Leistungswerte und deren absoluten Leistungsänderungen bestimmt.

Die Reihenfolge der optionalen Verfahrensschritte 68 und 70 ist beliebig miteinander vertauschbar.

Mit anderen Worten kann vor dem ersten Verfahrensschritt 50 erst eine relative Kalibrierung und dann eine absolute Kalibrierung der Messanordnung 10 erfolgen oder vice versa.

**Bezugszeichenliste**

| | |
|---|---|
| 10 | Messanordnung |
| 12 | Störquelle |
| 14 | Messsystem |
| 16 | Kopplungseinheit |
| 18 | Speichereinheit |
| 20 | Prozessor |
| 22 | Quelle zum Erzeugen von Modulationssignalen |
| 24 | Spannungsquelle |
| 26 | erste Kalibriereinheit |
| 28 | zweite Kalibriereinheit |
| 30 | Schaltungseinheit |

| | |
|---|---|
| 50 | erster Verfahrensschritt - Verbinden der Störquelle |
| 52 | zweiter Verfahrensschritt - Herstellen erster Lastzustand |
| 54 | dritter Verfahrensschritt - Auskoppeln und Weiterleiten von HF-Signalen |
| 56 | vierter Verfahrensschritt - Herstellen zweiter Lastzustand |
| 58 | fünfter Verfahrensschritt - Auskoppeln und Weiterleiten von HF-Signalen |
| 60 | sechster Verfahrensschritt - Ermitteln von absoluten Wellengrößen |
| 62 | siebter Verfahrensschritt - Bestimmen von Strömen und Spannungen |
| 64 | achter Verfahrensschritt - Bestimmen der Impedanz |
| 66 | neunter Verfahrensschritt - Bestimmen der Störquellenspannung |
| 68 | erster optionaler Verfahrensschritt - Durchführen einer relativen Kalibrierung |
| 70 | zweiter optionaler Verfahrensschritt - Durchführen einer absoluten Kalibrierung |

**Patentansprüche**

1. Verfahren zum Bestimmen von elektrischen Größen für ein Verhaltensmodell einer elektrischen oder elektronischen Störquelle (12), welches die Schritte aufweist:

   - Verbinden (50) eines ersten Ports einer Kopplungseinheit (16) mit der Störquelle (12),
   - Herstellen (52) eines ersten Lastzustands durch Einspeisen eines ersten Modulationssignals ($a_{mod}'$) in die Kopplungseinheit (16) durch ein mit einem zweiten Port der Kopplungseinheit (16) verbundenes Messsystem (14),
   - Auskoppeln und Weiterleiten (54) von in dem ersten Lastzustand an dem ersten Port anliegenden hochfrequenten Signalen an das Messsystem (14),
   - Herstellen (56) eines zweiten Lastzustands durch Einspeisen eines von dem ersten Modulationssignal ($a_{mod}'$) unterschiedlichen zweiten Modulationssignals ($a_{mod}''$) in die Kopplungseinheit (16) durch das Messsystem (14),
   - Auskoppeln und Weiterleiten (58) von in dem zweiten Lastzustand an dem ersten Port anliegenden hochfrequenten Signalen an das Messsystem (14),
   - Ermitteln (60) von absoluten Wellengrößen ($a1, b1$) aus den jeweils in den beiden Lastzuständen ausgekoppelten hochfrequenten Signalen basierend auf in einer Speichereinheit (18) des Messsystems (14) hinterlegten Ergebnissen einer relativen und einer absoluten Kalibrierung der mit dem Messsystem (14) verbundenen Kopplungseinheit (16),
   - Bestimmen (62) der Ströme und Spannungen in den beiden Lastzuständen basierend auf den absoluten Wellengrößen ($a1, b1$),
   - Bestimmen (64) einer Impedanz ($Z_s$) ausgehend von einem Verhältnis einer durch die zwei Lastzustände hervorgerufenen Spannungsdifferenz zu einer hervorgerufenen Stromdifferenz und
   - Bestimmen (66) einer Störquellenspannung ($U_s$), eines Störquellenstroms ($I_s$) und/oder einer Störleistungswelle ($a_0$) basierend auf der Impedanz ($Z_s$).

2. Verfahren nach Anspruch 1, wobei vor dem Verbinden (50) des ersten Ports der Kopplungseinheit (16) mit der Störquelle (12) folgende Schritte durchgeführt werden:

   - Verbinden des ersten Ports der Kopplungseinheit (16) mit einer ersten Kalibriereinheit (26),
   - Durchführen (68) einer relativen Kalibrierung der mit dem Messsystem (14) verbundenen Kopplungseinheit (16) unter Verwendung der ersten Kalibriereinheit (26) und des Messsystems (14),
   - Hinterlegen des Ergebnisses der relativen Kalibrierung in der Speichereinheit (18) des Messsystems (14) und
   - Trennen des ersten Ports der Kopplungseinheit (16) von der ersten Kalibriereinheit (26).

3. Verfahren nach dem vorangehenden Anspruch, wobei ein 3-Term-Kalibrierungsverfahren durchgeführt wird.

4. Verfahren nach einem der vorangehenden Ansprüche, wobei vor dem Verbinden (50) des ersten Ports der Kopplungseinheit (16) mit der Störquelle (12) folgende Schritte durchgeführt werden:

- Verbinden des ersten Ports der Kopplungseinheit (16) mit einer zweiten Kalibriereinheit (28),
- Durchführen (70) einer absoluten Kalibrierung der mit dem Messsystem (14) verbundenen Kopplungseinheit (16) unter Verwendung der zweiten Kalibriereinheit (28) und des Messsystems (14),
- Hinterlegen des Ergebnisses der absoluten Kalibrierung in der Speichereinheit (18) des Messsystems (14) und
- Trennen des ersten Ports der Kopplungseinheit (16) von der zweiten Kalibriereinheit (28).

5. Verfahren nach einem der Ansprüche 2 bis 4, wobei das jeweilige Verbinden und Trennen der ersten Kalibriereinheit (26), der zweiten Kalibriereinheit (28) und/oder der Störquelle (12) mit oder von dem ersten Port der Kopplungseinheit (16) selektiv mittels einer Schaltungseinheit (30) erfolgt.

6. Verfahren nach Anspruch 5, wobei das Messsystem (14) die Schaltungseinheit (30) derart ansteuert, dass vor einem jeden Verbinden (50) des ersten Ports der Kopplungseinheit (16) mit der Störquelle (12), eine absolute und/oder relative Kalibrierung der mit dem Messsystem (14) verbundenen Kopplungseinheit (16) durchgeführt und die jeweiligen Ergebnisse in der Speichereinheit (18) des Messsystems (14) hinterlegt werden.

7. Verfahren nach einem der vorangehenden Ansprüche, wobei das Messsystem (14) eine Quelle (22) zum Erzeugen von sinusodialen und/oder arbiträren Modulationssignalen umfasst oder mit einer derartigen Quelle gekoppelt ist.

8. Verfahren nach dem vorangehenden Anspruch, wobei das Messsystem (14) als ein Software-Defined-Radio (SDR)-Messsystem ausgestaltet ist, welches einen Arbiträrgenerator zum Erzeugen von arbiträren Modulationssignalen umfasst.

9. Verfahren nach einem der vorangehenden Ansprüche, wobei die Kopplungseinheit (16) in Form eines Diplexers ausgestaltet ist und ein Gleichspannungssignal von einer Spannungsquelle (24) zur elektrischen Versorgung der Störquelle (12) in einer von dem zweiten Port entkoppelten Leitung des Diplexers eingespeist wird.

10. Verfahren nach einem der vorangehenden Ansprüche, wobei das erste und/oder das zweite Modulationssignal ($a_{mod}$', $a_{mod}$") eine Signaldauer von bis zu 1 s, bevorzugt bis zu 50 ms, vorzugsweise bis zu 10 ms, besonders bevorzugt bis zu 5 ms, aufweisen.

11. Verfahren nach einem der vorangehenden Ansprüche, wobei die Kopplungseinheit (16) mindestens einen weiteren Port zum Verbinden mit einer weiteren elektrischen oder elektronischen Störquelle (12) umfasst und das Messsystem (14) eine Mehrleitermessung an dem ersten Port und dem weiteren Port zur Bestimmung einer Störquellenspannung ($U_s$), eines Störquellenstroms ($I_s$) und/oder einer Störleistungswelle ($a_0$) der jeweiligen Störquelle (12) durchführt.

12. Verfahren nach dem der vorangehenden Anspruch, wobei in beide Richtungen durch den ersten Port und/oder den weiteren Port der Kopplungseinheit (16) laufende Anteile der hochfrequenten Signale in den beiden Lastzuständen mittels Homodynempfängern, Heterodynempfängern und/oder einer Zeitbereichsmesseinrichtung des Messsystems (14) erfasst und basierend darauf die jeweiligen absoluten Wellengrößen (a1, b1) bestimmt werden.

13. Messanordnung (10) zum Bestimmen von elektrischen Größen für ein Verhaltensmodell einer elektrischen oder elektronischen Störquelle (12), umfassend:

- ein Messsystem (14) und
- eine Kopplungseinheit (16) mit einem ersten Port zum Verbinden der Störquelle (12) mit einer Last über eine verbindende Leitung und einem zweiten Port, über welchen die Kopplungseinheit (16) mit dem Messsystem (14) verbunden ist,

wobei das Messsystem (14) eine Speichereinheit (18) mit hinterlegten Ergebnissen einer relativen und einer absoluten Kalibrierung der mit dem Messsystem (14) verbundenen Kopplungseinheit (16) und einen Prozessor (20) umfasst, der dazu eingerichtet ist, die folgenden Schritte durchzuführen:

- Erzeugen und Einspeisen eines ersten Modulationssignals ($a_{mod}$') in die Kopplungseinheit (16) zum Herstellen eines ersten Lastzustands,
- Empfangen von in dem ersten Lastzustand an dem ersten Port anliegenden hochfrequenten Signalen,
- Erzeugen und Einspeisen eines von dem ersten Modulationssignal ($a_{mod}$') unterschiedlichen zweiten Modulationssignals ($a_{mod}$") zum Herstellen eines zweiten Lastzustands,
- Empfangen von in dem zweiten Lastzustand an dem ersten Port anliegenden hochfrequenten Signalen,

- Ermitteln von absoluten Wellengrößen (a1, b1) aus den jeweils in den beiden Lastzuständen empfangenen hochfrequenten Signalen basierend auf den in der Speichereinheit (18) hinterlegten Ergebnissen,

- Bestimmen der Ströme und Spannungen in den beiden Lastzuständen basierend auf den absoluten Wellengrößen (a1, b1),

- Bestimmen einer Impedanz ($Z_s$) ausgehend von einem Verhältnis einer durch die zwei Lastzustände hervorgerufenen Spannungsdifferenz zu einer hervorgerufenen Stromdifferenz und

- Bestimmen einer Störquellenspannung ($U_s$), eines Störquellenstroms ($I_s$) und/oder einer Störleistungswelle ($a_0$) basierend auf der Impedanz ($Z_s$)).

14. Computerprogramm, umfassend Befehle, die bei der Ausführung des Programms durch einen Computer diesen veranlassen, das Verfahren nach einem der Ansprüche 1 bis 12 auszuführen.

15. Maschinenlesbares Speichermedium, auf welchem ein Computerprogramm nach Anspruch 14 hinterlegt ist.

$Z_L$

$Z_S$

$I_K^{'(")}$

$U_L^{'(")}$

$U_K^{'(")}$

$U_S$

**Fig. 1**

10

$Z_S, U_S, I_S, a_0$

18   20   14   22

$a_{mod}$   b1   a1   b1

a1

24   16   12

**Fig. 2**

$Z_S, U_S, I_S, a_0$

Fig. 3

Fig. 4

Nummer der Anmeldung

EP 25 21 9849

Europäisches
Patentamt
European
Patent Office
Office européen
des brevets

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2021 214761 B3 (VOLKSWAGEN AG [DE]) 25. Mai 2023 (2023-05-25) <br> * Ansprüche 1,4 * <br> * Abbildungen 2,20-21 * <br> * Absatz [0024] * <br> * Absatz [0046] * <br> * Absatz [0055] * <br> ----- | 1-15 | INV. <br> G01R31/00 |
| Y | JP 2021 022387 A (ROHM CO LTD) 18. Februar 2021 (2021-02-18) <br> * Abbildung 2 * <br> * Absatz [0024] * <br> ----- | 1-15 | |

RECHERCHIERTE
SACHGEBIETE (IPC)

G01R
G06F

Der vorliegende Recherchenbericht wurde für alle Patentansprüche erstellt

| Recherchenort | Abschlußdatum der Recherche | Prüfer |
|---|---|---|
| Den Haag | 2. April 2026 | Rambaud, Patrick |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
..........................................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 21 9849

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-04-2026

| Im Recherchenbericht angeführtes Patentdokument | Datum der Veröffentlichung | Mitglied(er) der Patentfamilie | Datum der Veröffentlichung |
|---|---|---|---|
| DE 102021214761 B3 | 25-05-2023 | KEINE | |
| JP 2021022387 A | 18-02-2021 | KEINE | |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 102021214761 B3
- WO 2021136792 A1
- DE 102019212808 A1
- US 20130238264 A1